Europäisches Patentamt

(19) **European Patent Office**

**Office européen des brevets**

(11) Numéro de publication: **0 085 600**
**A1**

(12) **DEMANDE DE BREVET EUROPEEN**

(21) Numéro de dépôt: **83400124.0**

(22) Date de dépôt: **19.01.83**

(51) Int. Cl.³: **H 03 F 1/32**

(30) Priorité: **29.01.82 FR 8201454**

(43) Date de publication de la demande:
**10.08.83 Bulletin 83/32**

(84) Etats contractants désignés:
**CH DE GB IT LI NL**

(71) Demandeur: **THOMSON-CSF**
**173, Boulevard Haussmann**
**F-75379 Paris Cedex 08(FR)**

(72) Inventeur: **Gaudin, Daniel**
**THOMSON-CSF SCPI 173, bld Haussmann**
**F-75379 Paris Cedex 08(FR)**

(74) Mandataire: **El Manouni, Josiane et al,**
**THOMSON-CSF SCPI 173, Bld Haussmann**
**F-75379 Paris Cedex 08(FR)**

(54) **Dispositif de correction d'intermodulation produite par un amplificateur de signaux haute fréquence régulé en niveau crête.**

(57) Ce dispositif de correction d'intermodulation produite par un amplificateur (1) de signaux haute fréquence, à coefficients de non linéarité complexes, comporte des moyens (2) d'élaboration de raies correctrices pour élaborer, à partir du signal haute fréquence à amplifier, un signal d'entrée de l'amplificateur (1) dont le spectre comporte, outre les raies haute fréquence du signal à amplifier, des premières raies correctrices haute fréquence, d'amplitude réglable, aux fréquences des produits d'intermodulation d'ordres impairs, et des secondes raies correctrices haute fréquence, d'amplitude réglable, aux fréquences des produits d'intermodulation d'ordres impairs, et déphasées de π/2, par rapport aux premières raies correctrices, le produit des fonctions de transfert des moyens (2) d'élaboration de raies correctrices et de l'amplificateur (1) ne donnant pas nécessairement une fonction de transfert linéaire.

Application aux émetteurs HF.

Fig.1a

Fig.1b

0085600

## DISPOSITIF DE CORRECTION D'INTERMODULATION PRODUITE PAR UN AMPLIFICATEUR DE SIGNAUX HAUTE FREQUENCE REGULE EN NIVEAU CRETE

La présente invention concerne un dispositif de correction d'intermodulation produite par un amplificateur de signaux haute fréquence régulé en niveau crête.

La non linéarité d'un amplificateur provoque, lorsqu'il est excité simultanément par plusieurs signaux de fréquences différentes, des signaux parasites appelés produits d'intermodulation.

Lorsque les signaux haute fréquence à amplifier sont des signaux modulés, le phénomène d'intermodulation se traduit alors, en dehors de la bande de modulation, par une perturbation des communications utilisant des canaux voisins, et dans la bande de modulation, par une distorsion phonique et surtout par un accroissement du taux d'erreur en cas de transmission numérique multiporteuse.

Pour éviter de pareils effets, il convient de minimiser les conséquences du phénomène de non linéarité.

Diverses solutions ont été proposées pour cela. Elles peuvent se classer en deux catégories : les dispositifs à asservissement permanent et les dispositifs précorrecteurs.

Les dispositifs à asservissement permanent consistent à faire une contre-réaction des divers paramètres du signal à amplifier. Comme tous les systèmes bouclés ces dispositifs peuvent donner lieu à des parasites transistoires après une phase de silence.

Les dispositifs précorrecteurs connus tendent à redonner globalement, c'est-à-dire y compris l'amplificateur à corriger, une fonction de transfert rectiligne, en compensant à la fois les termes de puissances paires et les termes de puissances impaires de la fonction de transfert de l'amplificateur à corriger.

Tous ces dispositifs ont en commun une grande complexité de réalisation et de mise au point. Par ailleurs ils doivent être conçus en fonction des amplificateurs qu'ils doivent corriger et ne sont jamais transposables directement à d'autres amplificateurs. De plus, il s'ap-

pliquent difficilement aux amplificateurs large bande.

Pour remédier à ces inconvénients, on a proposé dans la demande de brevet français n° 81 10 451 déposée le 26 mai 1981 au nom de la demanderesse, un dispositif de correction de non linéarité qui se différencie ·essentiellement des précorrecteurs connus en ce que le produit des fonctions de transfert du précorrecteur et de l'amplificateur non linéaire ne donne pas obligatoirement une fonction de transfert linéaire.

Le dispositif de correction qui fait l'objet de la demande de brevet précitée ne tend en effet à annuler que les produits d'intermodulation d'ordres impairs issus des termes de puissances impaires de la fonction de transfert de l'amplificateur à corriger, seuls générateurs des produits d'intermodulation au voisinage du canal d'émission. Ce dispositif comporte pour cela des moyens pour élaborer, à partir du signal haute fréquence à amplifier, un signal d'entrée de l'amplificateur dont le spectre comporte, outre les tons haute fréquence à amplifier, des tons haute fréquence aux fréquences des produits d'intermodulation d'ordres impairs, d'amplitude réglable.

Le dispositif de correction d'intermodulation qui fait l'objet de la demande de brevet précitée n'est toutefois applicable que lorsque les coefficients de non linéarité de l'amplificateur, qui sont les coefficients du polynôme de Volterra appliqué à sa fonction de transfert, ont des valeurs réelles, c'est-à-dire lorsque l'amplificateur à corriger présente seulement des non linéarités d'amplitude.

Or ces coefficients de non linéarité sont en général complexes, et il ne suffit pas de corriger uniquement la distorsion en amplitude mais il est important de corriger également la distorsion en phase, même si souvent cette distorsion de phase se traduit par des défauts d'intermodulation inférieurs à ceux que provoque la distorsion d'amplitude. Autrement dit une correction exclusive sur la non-linéarité d'amplitude ne permet pas aux vecteurs correcteurs de se trouver exactement en opposition avec les vecteurs à corriger si l'amplificateur présente une légère non linéarité de phase.

La présente invention a pour objet un dispositif de correction d'intermodulation permettant de corriger à la fois les produits d'intermodulation d'ordres impairs dus à la partie réelle des coefficients de non linéarité de l'amplificateur et les produits d'intermodulation d'ordres impairs dus à la partie imaginaire des coefficients de non linéarité de l'amplificateur.

Selon l'invention le dispositif de correction d'intermodulation produite par un amplificateur de signaux haute fréquence, régulé en niveau crête, à coefficients de non linéarité complexes, comporte des moyens d'élaboration de raies correctrices, pour élaborer, à partir du signal haute fréquence à amplifier, un signal d'entrée de l'amplificateur dont le spectre comporte, outre les raies haute fréquence du signal à amplifier, des premières raies correctrices d'amplitude réglable, aux fréquences des produits d'intermodulation d'ordres impairs, et des secondes raies correctrices d'amplitude réglable, aux fréquences des produits d'intermodulation d'ordres impairs, et déphasées de $\frac{\pi}{2}$ par rapport aux premières raies correctrices, le produit des fonctions de transfert des moyens d'élaboration de raies correctrices et de l'amplificateur ne donnant pas nécessairement une fonction de transfert linéaire.

Les objets et caractéristiques de la présente invention apparaitront plus clairement à la lecture de la description suivante d'exemples de réalisation, ladite description étant faite en relation avec les dessins ci-annexés dans lesquels :

- la figure 1a est un schéma d'un dispositif de correction d'intermodulation selon un premier exemple de réalisation de l'invention ;

- la figure 1b est un schéma d'un dispositif de correction d'intermodulation selon un second exemple de réalisation de l'invention (des éléments identiques sur les figures 1a et 1b portent les mêmes références) ;

- les figures 2a et 2b représentent la fonction de transfert d'un élément non linéaire et donnent respectivement l'amplitude de la non linéarité sur l'axe des réels (X) et sur l'axe des imaginaires (Y), en fonction de l'amplitude $V_e$ du signal d'entrée de l'élément non linéaire ;

- les figures 2c et 2d représentent la même chose que les figures 2a et 2b mais en coordonnées polaires, les coordonnées polaires étant plus couramment utilisées pour caractériser les non linéarités d'amplitude et les non linéarités de phase d'un élément de puissance, en fonction de l'amplitude du signal d'entrée ;

- les figures 3a et 3b représentent les défauts d'intermodultation respectivement en représentation spectrale et vectorielle de Fresnel à un instant donné ;

- les figures 4a et 4b représentant les spectres de signaux obtenus à partir de l'enveloppe du signal d'entrée et utilisés respectivement pour l'élaboration des premières et des secondes raies correctrices ;

- la figure 4c représente le spectre d'attaque de l'amplificateur à corriger ;

- les figures 5a et 5b sont respectivement des représentations spectrale et vectorielle d'un ton haute fréquence modulé en amplitude par un ton basse fréquence ;

- les figures 5c et 5d sont respectivement des représentations spectrale et vectorielle de deux tons haute fréquence modulés en amplitude par un même ton basse fréquence ;

- la figure 6a rappelle en représentation vectorielle la position des raies d'intermodulation d'ordre 3 à un instant donné tandis que la figure 6b montre le maximum de correction obtenu par action exclusive sur l'amplitude ;

- les figures 7a et 7b sont respectivement des représentations spectrale et vectorielle d'un ton haute fréquence modulé en phase ;

- les figures 7c et 7d sont respectivement des représentations spectrale et vectorielle de deux tons haute fréquence modulés en phase par un même ton basse fréquence ;

- la figure 8a montre la combinaison vectorielle de deux tons haute fréquence modulés en phase et en amplitude par un même ton basse fréquence ;

- la figure 8b montre la modulation composite d'un ton, en phase et en amplitude, avec équivalence entre les représentations complexes et polaires.

Dans une mesure en deux tons du type CCIR, on entend par produits d'intermodulation d'ordres impairs les raies du spectre du signal de sortie d'un élément non linéaire se situant aux fréquences $n f_1 - (n-1) f_2$ et $n f_2 - (n-1) f_1$ où n est un nombre entier et $f_1$ et $f_2$ les fréquences d'émission.

A titre d'exemple, on décrit un dispositif de correction des produits d'intermodulation d'ordre 3 et 5, c'est-à-dire issus des termes de puissance égale à 3 et 5 de la fonction de transfert de l'amplificateur 1, mais le principe de l'invention reste valable pour la correction des produits d'intermodulation d'ordre supérieur à 5.

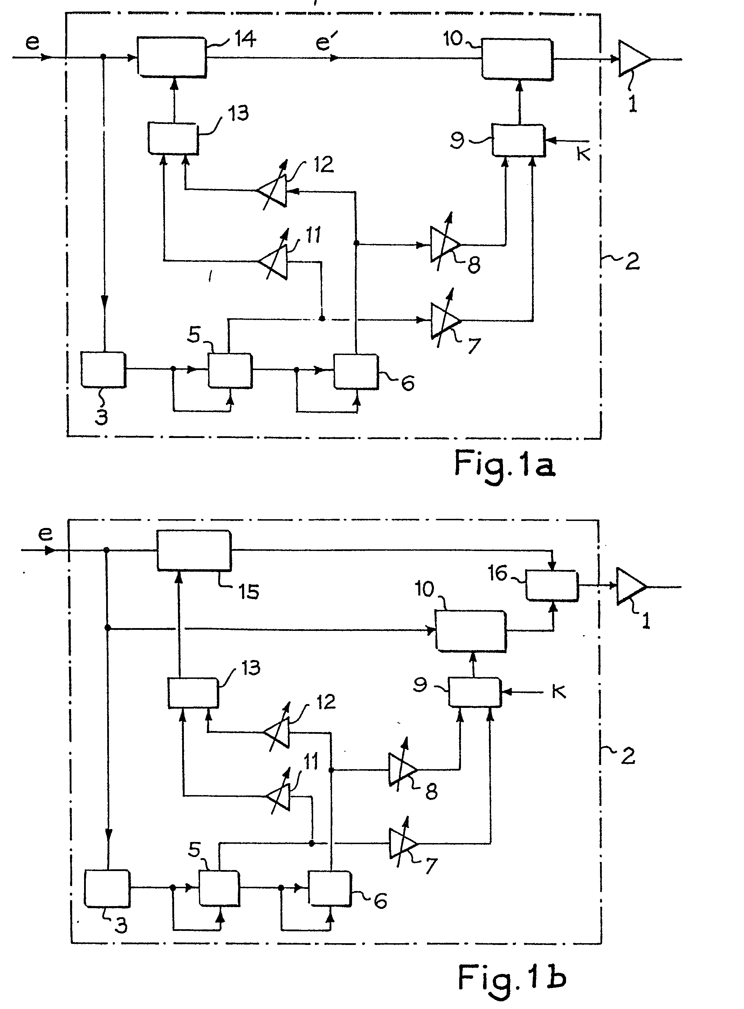

Sur la figure 1a on a représenté un amplificateur non linéaire 1 destiné à amplifier un signal d'entrée e de haute fréquence.

Un dispositif 2 de correction d'intermodulation produite par l'amplificateur 1 est disposé en amont de cet amplificateur.

Il est prévu en entrée du dispositif de correction 2 un détecteur 3 de l'enveloppe D du signal d'entrée e. Le détecteur 3 est constitué par exemple par un montage du type "diode sans seuil".

Dans le cadre de l'exemple choisi pour la description, le dispositif 2 de correction d'intermodulation comporte un premier multiplieur 5 muni de deux entrées reliées à la sortie du détecteur d'enveloppe 3, et un second multiplieur 6 muni de deux entrées reliées à la sortie du premier multiplieur 5.

Le dispositif 2 comporte également un premier amplificateur à gain réglable 7, muni d'une entrée reliée à la sortie du premier multiplieur 5, et un second amplificateur à gain réglable 8, muni d'une entrée reliée à la sortie du second multiplieur 6. Les amplificateurs 7 et 8 sont des amplificateurs linéaires, par exemple des amplificateurs opérationnels bouclés à l'aide d'une résistance.

Le dispositif 2 comporte également un circuit sommateur 9 muni d'une première entrée reliée à la sortie de l'amplificateur 7, d'une deuxième entrée reliée à la sortie de l'amplificateur 8 et d'une troisième entrée destinée à recevoir une valeur constante K déterminée par l'opérateur en fonction du point de fonctionnement désiré.

Le dispositif 2 comporte encore un troisième amplificateur à gain réglable 11 muni d'une entrée reliée à la sortie du premier multiplieur 5 et un quatrième amplificateur à gain réglable 12 dont l'entrée est reliée à la sortie du deuxième multiplieur 6. Ces amplificateurs 11 et 12 sont des amplificateurs linéaires, par exemple des amplificateurs opérationnels bouclés à l'aide d'une résistance.

Le dispositif 2 comporte également un circuit sommateur 13 muni d'une première entrée reliée à la sortie de l'amplificateur 11 et d'une seconde entrée reliée à la sortie de l'amplificateur 12.

Il est à remarquer que tous les amplificateurs à gain réglable 7, 8, 11, 12 sont réglables algébriquement. Le signe et la valeur du gain sont déterminés par l'opérateur.

Plus généralement, le dispositif 2 comporte N multiplieurs dont le premier est muni de deux entrées reliées à la sortie du détecteur d'enveloppe, dont le deuxième est muni de deux entrées reliées à la sortie du premier et dont le $n^{\text{ième}}$ (n étant un entier compris entre 3 et N) est muni de deux entrées reliées respectivement à la sortie du premier et du $(n-1)^{\text{ième}}$, 2N amplificateurs linéaires à gain réglable munis chacun d'une entrée reliée à la sortie de l'un des N multiplieurs, et deux circuits sommateurs dont le premier comporte N + 1 entrées, N de ces entrées étant reliées aux sorties de N amplificateurs à gain réglable et la $(N + 1)^{\text{ième}}$ recevant une constante K, et dont le second comporte uniquement N entrées reliées aux sorties des N autres amplificateurs à gain réglable.

Le dispositif 2 comporte en outre un mélangeur 10 utilisé en modulateur d'amplitude, muni d'une entrée haute fréquence qui reçoit un signal e', d'une entrée basse fréquence reliée à la sortie du circuit sommateur 9, et d'une sortie qui constitue la sortie du dispositif 2 et qui est reliée à l'entrée de l'amplificateur 1. Le mélangeur 10 est destiné à effectuer le produit des signaux présents sur ses deux entrées.

Le dispositif 2 comporte enfin un modulateur de phase 14 qui reçoit sur son entrée haute fréquence le signal e. L'entrée basse fréquence du modulateur de phase 14 est reliée à la sortie du sommateur 13. La sortie du modulateur de phase 14 délivre le signal e' qui est reçu sur l'entrée haute fréquence du mélangeur 10.

Une variante de ce dispositif 2 est représentée sur la figure 1b .

Le dispositif représenté sur la figure 1b est identique au dispositif représenté sur la figure 1a, à l'exception du modulateur de phase 14 qui est remplacé par un dispositif 15 légèrement différent du modulateur 14 en ce sens qu'il ne délivre pas la porteuse, mais seulement les raies de modulation. Le dispositif 15 est par exemple obtenu par disposition, en sortie d'un modulateur de phase, d'un filtre destiné à éliminer la porteuse. De plus, contrairement à la figure 1a, le mélangeur 10 et le dispositif 15 reçoivent tous les deux sur leur entrée haute fréquence le signal d'entrée e, et le signal de sortie du dispositif 2 est alors obtenu par addition dans un sommateur final 16, des raies de modulation en phase correctrices issues du dispositif 15 et des raies principales et des raies de modulation en amplitude correctrices issues du mélangeur 10.

Cette variante de réalisation évite les perturbations au second degré auxquelles donne lieu le montage de la figure 1a. Par exemple, dans le montage de la figure 1a, les raies correctrices issues du modulateur de phase 14 pour corriger l'intermodulation d'ordre 3 peuvent donner lieu à des raies aux fréquences de l'intermodulation d'ordre 5 par modulation dans le mélangeur 10 suivant. Ceci atteint toutefois dans la pratique des niveaux vraiment très bas (inférieurs à 60 dB), ce qui rend le montage de la figure 1a tout à fait acceptable.

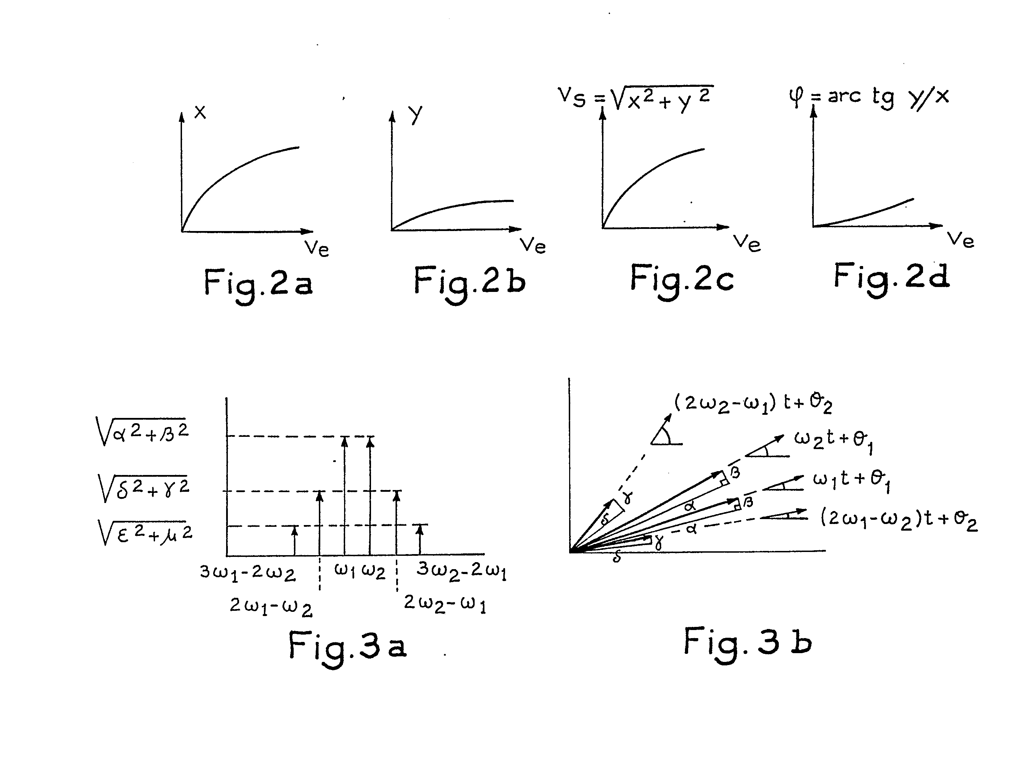

Le fonctionnement du dispositif 2 de correction d'intermodulation conforme à l'invention est maintenant expliqué en relation avec les figures 2, 3, 4, 5, 6, 7 et 8.

Il est tout d'abord important de voir la relation entre les raies principales et les raies d'intermodulation produites par un amplificateur non linéaire. Soient $e(t)$ et $s(t)$ les signaux d'entrée et de sortie de cet amplificateur ; on a entre $e(t)$ et $s(t)$ une relation du type :

$$s(t) = ae(t) + be^2(t) + ce^3(t) + ... \text{ etc}$$ où $a$, $b$, $c$,...etc sont les coefficients de non linéarité, c'est-à-dire des coefficients complexes définissant les non linéarités en amplitude et en phase de l'amplificateur. Les termes pairs de $s(t)$ ($e^2$, $e^4$ ...etc) ne produisent pas de raies parasites au voisinage des fréquences d'émission et ne sont donc pas gênants puisque, dans le cadre de la présente invention, on se préoccupe uniquement de la correction des produits d'intermodulation qui se trouvent au voisinage des fréquences d'émission, c'est-à-dire des produits d'intermodulation d'ordres impairs, en supposant par exemple que l'amplificateur non linéaire dispose de filtres harmoniques, et ne puisse par ailleurs laisser passer de signal continu ou un spectre basse fréquence où peuvent

0085600

8

se trouver certaines raies d'intermodulation d'ordre pair. Il suffit donc d'étudier une non linéarité ne comportant que des puissances impaires.

L'exposé est fait en se limitant aux distorsions en $e^3$ (t) pour des raisons évidentes de clarté mais le principe est valable pour toutes les puissances impaires. Dans la pratique, à partir de l'ordre 7 les niveaux d'intermodulation sont négligeables.

Soit une non linéarité telle que pour un signal d'entrée e (t) on ait en sortie un signal :

$$s(t) = a\, e\,(t) + b\, e^3\,(t)$$

avec $a = m + j\, n$

$b = p + j\, q$

j étant le nombre complexe tel que $j^2$ est égal à $-1$ et m, n, p, q étant des nombres réels.

L'étude est faite en 2 tons égaux selon la méthode recommandée par le CCIR mais le principe reste valable pour deux tons inégaux ou pour n tons quelconques à condition toutefois de conserver la même puissance crête, ce qui permet de parcourir toujours la même courbe de transfert de l'élément non linéaire. En effet, les termes m, n, p, q etc... dépendent de l'excursion que l'on fait sur les courbes de transfert représentées aux figures 2a et 2b, et en toute rigueur, le dispositif de correction assure les meilleurs résultats si le signal de travail comporte la même excursion que le signal de test utilisé pour l'optimisation des coefficients du dispositif de correction.

Soit $e(t) = \cos w_1 t + \cos w_2 t$.

En effectuant le calcul, on trouve que le signal s (t) correspondant possède huit composantes spectrales : deux raies principales aux fréquences $f_1$ et $f_2$, deux raies d'intermodulation aux fréquences $2f_1 - f_2$ et $2f_2 - f_1$, deux raies d'intermodulation aux fréquences $2f_1 + f_2$ et $2f_2 + f_1$, donc au voisinage des harmoniques 3, et deux harmoniques 3 aux fréquences $3f_1$ et $3f_2$.

Le signal utile a donc pour équation après filtrage harmonique :

$$s\,(t) = \alpha\,(\cos w_1 t + \cos w_2 t) + j\,\beta\,(\cos w_1 t + \cos w_2 t)$$
$$+ \delta\,[\cos (2w_1 - w_2)\,t + \cos (2w_2 - w_1)\,t]$$
$$+ j\,\gamma\,[\cos (2w_1 - w_2)\,t + \cos (2w_2 - w_1)\,t\,]$$

où $\alpha, \beta$ , $\delta$ et $\gamma$ sont des nombres réels.

Un tel signal est représenté en spectre sur la figure 3a et en phase à un instant donné selon la représentation vectorielle de Fresnel sur la figure 3b. Sur la figure 3a on a également représenté les distorsions d'ordre 5, ce qui n'alourdit pas le diagramme :

$$\varepsilon \; [\cos (3w_1 - 2w_2) t + \cos (3w_2 - 2w_1) t]$$
$$+ j\mu \; [\cos (3w_1 - 2w_2) t + \cos (3w_2 - 2w_1) t]$$

où $\varepsilon$ et $\mu$ sont également des nombres réels.

Sur la figure 3b, $\theta_1$ et $\theta_2$ indiquent les distorsions de phase dues aux non linéarités de phase appliquées respectivement aux tons haute fréquence à amplifier et aux produits d'intermodulation d'ordre 3. $\theta_1$ est toujours négligeable ( $\beta$ étant très inférieur à $\alpha$).

Le fonctionnement du dispositif de correction est décrit ci-après.

Soit e (t) le signal d'entrée comportant 2 tons égaux aux fréquences $f_1$ et $f_2$ :

$$e(t) = \frac{A}{2} (\cos \; w_1 t + \cos \; w_2 t)$$

où A est un coefficient réel, ce qui s'écrit aussi :

$$e(t) = A \cos \; (\frac{w_1 + w_2}{2}) \, t \quad \cos \; (\frac{w_2 - w_1}{2}) \, t$$

On remarque qu'il s'agit du produit d'un signal haute fréquence par un signal basse fréquence. Le signal basse fréquence représente l'enveloppe du signal d'entrée :

$$D(t) = A \cos (\frac{w_2 - w_1}{2}) \; t$$

En sortie du premier multiplieur 5, on obtient :

$$D^2(t) = \frac{A^2}{2} [1 + \cos (w_2 - w_1) t]$$

et en sortie du second multiplieur 6 :

$$D^4(t) = \frac{A^4}{8} [3 + 4 \cos (w_2 - w_1) t + \cos 2 (w_2 - w_1) t]$$

Soient $k_7$ le gain de l'amplificateur 7, $k_8$ le gain de l'amplificateur 8, $k_{11}$ le gain de l'amplificateur 11 et $k_{12}$ le gain de l'amplificateur 12.

On obtient en sortie du sommateur 9 :

- une composante continue, d'amplitude $k_7 \; \frac{A^2}{2} + k_8 \; 3 \frac{A^4}{8} + K$

(K étant une constante extérieure assurant un gain unité au mélangeur 10 en l'absence de correction, les autres termes étant négligeables devant K)

- une composante à la pulsation $(w_2 - w_1)$, d'amplitude

$$k_7 \frac{A^2}{2} + k_8 \frac{A^4}{2}$$

- une composante à la pulsation $2(w_2 - w_1)$, d'amplitude

$$k_8 \frac{A^4}{8}$$

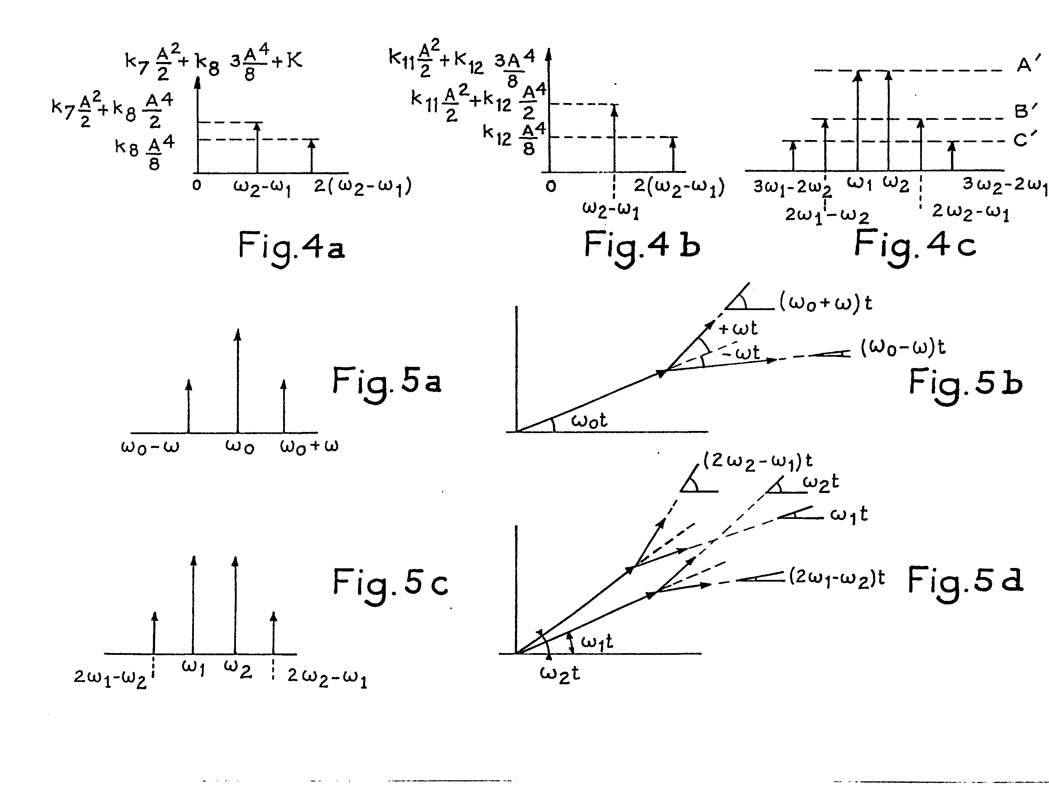

Les raies obtenues en sortie du sommateur 9 sont représentées à la figure 4a.

En sortie du sommateur 13 on obtient de même :

- une composante continue, d'amplitude $k_{11} \frac{A^2}{2} + k_{12} \frac{3 A^4}{8}$

- une composante à la pulsation $(w_2 - w_1)$, d'amplitude

$$k_{11} \frac{A^2}{2} + k_{12} \frac{A^4}{2}$$

.- une composante à la pulsation $2(w_2 - w_1)$, d'amplitude

$$k_{12} \frac{A^4}{8}$$

Les raies obtenues en sortie du sommateur 13 sont représentées à la figure 4b.

Si les défauts d'intermodulation ne proviennent que de coefficients réels, la commande du sommateur 13 est nulle et on obtient en sortie du modulateur de phase 14 directement le signal d'entrée.

A la sortie du mélangeur 10 on obtient alors :

$$\frac{A}{2} (\cos w_1 t + \cos w_2 t) \quad [A' + B' \cos (w_2 - w_1)t + C' \cos 2( w_2 - w_1) t]$$

où A', B' et C' sont coefficients réels avec, dans cette hypothèse, A' voisin de K, B' égal à $k_7 \frac{A^2}{2} + k_8 \frac{A^4}{2}$ et C' égal à $k_8 \frac{A^4}{8}$

En effectuant le calcul, on trouve six composantes spectrales : aux fréquences $f_1, f_2, 2f_1 - f_2, 2f_2 - f_1, 3f_1 - 2f_2$ et $3f_2 - 2f_1$.

Ce résultat apparait sur le spectre représenté à la figure 4c qui est le spectre du signal obtenu en sortie du mélangeur 10. Si l'on se réfère à l'étude de non linéarité de l'amplificateur faite précédemment, on s'aperçoit que ce spectre comporte des composantes situées aux mêmes fréquences que le spectre qui serait obtenu après une amplification non linéaire du signal d'entrée à travers l'amplificateur 1 non corrigé. On voit

11

donc qu'en choisissant correctement les valeurs B' et C', il est possible de neutraliser les composantes de fréquence $2f_1 - f_2$, $2f_2 - f_1$, $3f_1 - 2f_2$ et $3f_2 - 2f_1$ dues à la non linéarité de l'amplificateur 1.

Pour cela l'opérateur contrôle l'amplitude et le signe de chacune des composantes de sortie du circuit sommateur 9 en agissant sur le réglage algébrique du gain des amplificateurs 7 et 8.

Nous venons de voir que par traitement adéquat de l'enveloppe du signal d'entrée, il est possible d'élaborer un signal basse fréquence, tel que par modulation d'amplitude du signal d'attaque de l'amplificateur à corriger, il produise des raies aux fréquences de l'intermodulation d'ordre 3, d'ordre 5 et même d'ordre impair supérieur. Les diagrammes des figures 5a et 5b montrent une modulation d'amplitude d'un ton haute fréquence de pulsation $w_o$ par un autre ton basse fréquence de pulsation w. Les diagrammes des figures 5c et 5d montrent la modulation d'amplitude, en sortie du mélangeur 10, de deux tons haute fréquence $w_1$ et $w_2$ par un autre ton basse fréquence à la pulsation $(w_2 - w_1)$. Le dosage correct et non indépendant de l'amplitude des raies de modulation $(2w_2 - w_1)$ et $(2w_1 - w_2)$ permet d'annuler les raies d'intermodulation d'ordre 3 si ces dernières n'ont pas de composante de distorsion de phase.

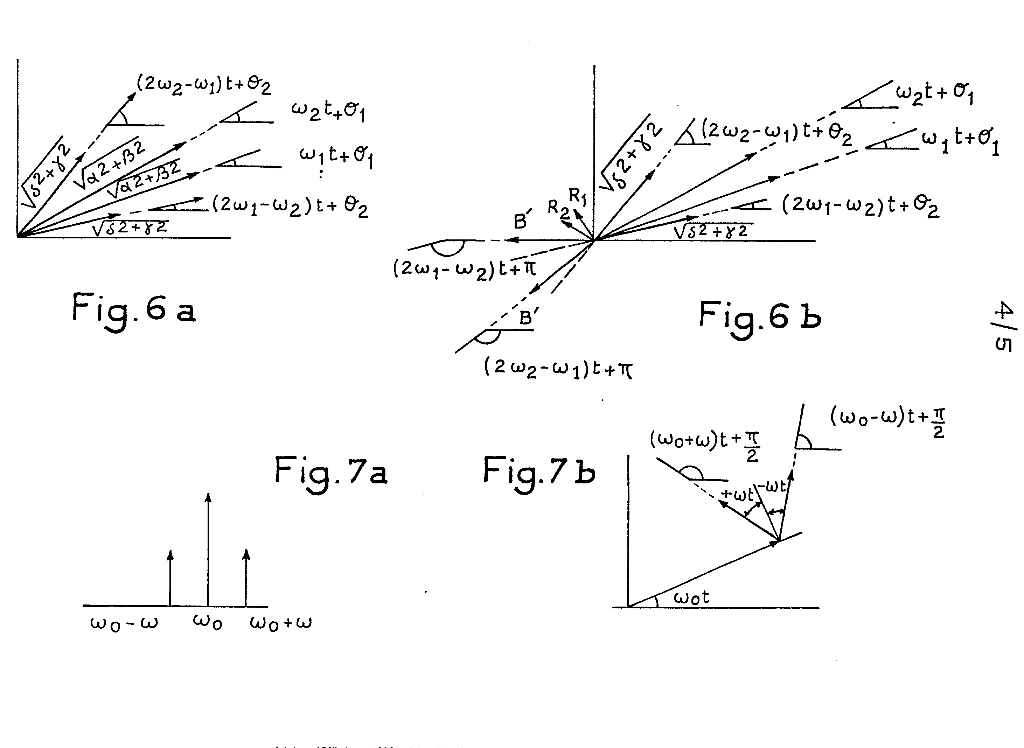

Mais dans le cas le plus général la non-linéarité répond au polynôme de Volterra à coefficients complexes, ce qui entraine en outre une distorsion de phase, imprimant alors une composante imaginaire aux raies principales et aux produits d'intermodulation (voir figure 6a) qu'il n'est pas possible d'annuler avec une seule correction de non linéarité d'amplitude. On voit en effet sur la figure 6b que les résultantes $\vec{R_1}$ et $\vec{R_2}$ des vecteurs à corriger et des vecteurs correcteurs, en ce qui concerne l'exer ple choisi des raies d'intermodulation d'ordre 3, ne sont pas nulles.

Il apparait alors qu'une combinaison vectorielle de chaque raie correctrice des non linéarités d'amplitude avec une composante déphasée de $\frac{\pi}{2}$ de cette raie correctrice des non linéarités d'amplitude permet de résoudre le problème de la correction simultanée des non linéarités d'amplitude et de phase.

Ceci peut être réalisé à l'aide d'un modulateur de phase 14 à indice de modulation suffisamment faible pour que le seul coefficient $J_1$ de Bessel soit significatif, ce qui est verifié largement par la pratique. Par exemple, pour un défaut d'intermodulation dû à la phase atteignant - 26 dB (ce qui est énorme) on a $J_o = 0,995$ $J_1 = 0,0499$ et $J_2 = 0,00124$. Ce dernier est négligeable et $J_o$ est voisin de 1. ($J_o$ et $J_1$ sont les coefficients de Bessel déterminant respectivement l'amplitude de la raie principale et des deux raies de modulation situées de part et d'autre de la raie principale dans le spectre d'un signal modulé en phase).

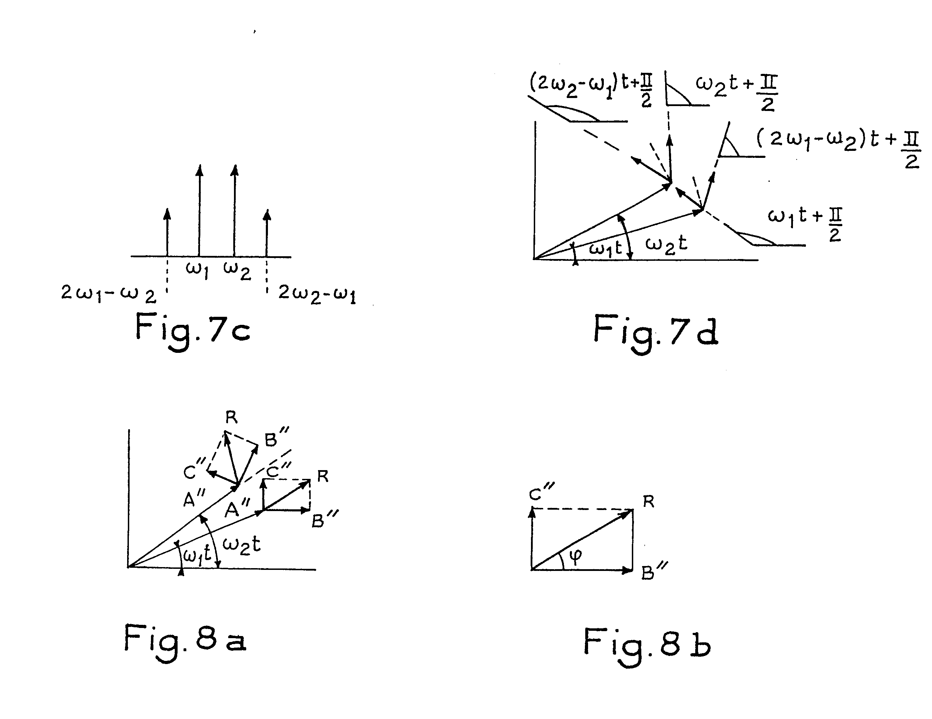

On a représenté une modulation de phase à faible indice, correspondant à une porteuse de pulsation $w_o$ modulée par un signal basse fréquence de pulsation w, aux figures 7a et 7b, et une modulation de phase correspondant à un signal deux tons $w_1$ et $w_2$ modulé par un signal basse fréquence ($w_2 - w_1$) aux figures 7c et 7d.

A la sortie du modulateur de phase 14, le signal est de la forme (pour l'intermodulation d'ordre 3 par exemple)

$$e' = \frac{A}{2} \cos [w_1 t + \Delta \phi k_{11} \cos (w_2 - w_1)t] +$$

$$\frac{A}{2} \cos[w_2 t + \Delta \phi k_{11} \cos (w_2 - w_1)t]$$

$\Delta \phi$ est la grandeur caractérisant la fonction de transfert propre du modulateur 14, représentant l'écart de phase entre e' et e pour un signal de modulation unité. $k_{11} \Delta \phi$ représente la même chose, tenant compte du réglage de l'amplificateur 11.

Pour $k_{11} \Delta \phi$ faible, $J_o$ est voisin de 1 et $J_2$ est très inférieur à $J_1$.

$$e' = \frac{A}{2} \cos w_1 t + \frac{A}{2} J_1 [\cos (w_2 t + \frac{\pi}{2}) + \cos [(2w_1 - w_2) t + \frac{\pi}{2}]] +$$

$$\frac{A}{2} \cos w_2 t + \frac{A}{2} J_1 [\cos (w_1 t + \frac{\pi}{2}) + \cos [(2w_2 - w_1) t + \frac{\pi}{2}]]$$

Le terme $J_1$ étant très faible (faible indice de modulation) les composantes $w_1$ et $w_2$ déphasées de $\frac{\pi}{2}$ sont négligeables par rapport aux raies principales $w_1$ et $w_2$.

Il reste :

$$e' = \frac{A}{2} [\cos w_1 t + \cos w_2 t]$$

$$+ \frac{A}{2} J_1 [\cos (2w_1 - w_2) t + \frac{\pi}{2}] + \frac{A}{2} J_1 [\cos (2w_2 - w_1) t + \frac{\pi}{2}]$$

Avec le montage de la figure 1a, c'est en fait le signal e' et non le signal e qui est modulé en amplitude par le mélangeur 10.

Les termes $\frac{A}{2} J_1 [\cos (2w_1 - w_2) t + \frac{\pi}{2}] + \frac{A}{2} J_1 [\cos (2w_2 - w_1) t + \frac{\pi}{2}]$ vont créer dans le modulateur 10 des défauts aux fréquences d'intermodulation d'ordre cinq mais leur niveau est négligeable ; c'est en fait de l'intermodulation au second degré. Si malgré tout on veut éviter ce défaut, on prendra le schéma de la figure 1b.

Afin de comprendre l'opération conjugée des deux modulations de phase et d'amplitude on se reporte aux figures 8a et 8b où la correction est représentée pour une intermodulation d'ordre 3. Seules les raies aux pulsations $(2w_1 - w_2)$ et $(2w_2 - w_1)$ sont repérées, les composantes retombant en $w_1$ et $w_2$ sont sans intérêt.

Le signal d'entrée de l'amplificateur 1 s'écrit en se limitant à la correction de l'intermodulation d'ordre 3 :

$S = A''[\cos\ w_1 t + \cos\ w_2 t]$

$+ B''[\cos\ (2w_1 - w_2) t + \cos\ (2w_2 - w_1) t]$

$+ C''[\cos\ [(2w_1 - w_2) t + \frac{\pi}{2}] + \cos\ [(2w_2 - w_1) t + \frac{\pi}{2}]]$

où A", B" et C" sont des coefficients réels.

Les deux raies principales d'amplitude A", de pulsation $w_1$ et $w_2$ sont obtenues dans le cas de la figure 1a à l'issue des deux opérations conjuguées de modulation de phase et de modulation d'amplitude et dans le cas de la figure 1b à l'issue de l'opération de modulation d'amplitude seule.

Les premières raies correctrices d'amplitude B", de pulsation $(2w_1 - w_2)$ et $(2w_2 - w_1)$ sont obtenues dans le cas de la figure 1a par modulation d'amplitude des raies principales . de pulsations $w_1$ et $w_2$ obtenues à l'issue de l'opération de modulation de phase à faible indice, et dans le cas de la figure 1b par modulation d'amplitude des tons haute fréquence de pulsations $w_1$ et $w_2$ présents directement à l'entrée du modulateur d'amplitude.

Les secondes raies correctrices d'amplitude C", déphasées de $\frac{\pi}{2}$ par rapport aux premières raies correctrices B" de pulsations $(2w_1 - w_2)$ et $(2w_2 - w_1)$, sont obtenues dans le cas de la figure 1a par modulation de phase des tons haute fréquence $w_1$ et $w_2$ du signal à amplifier (la modulation d'amplitude ultérieure ayant alors une action négligeable sur les raies de modulation de phase ainsi obtenues) et dans le cas de la figure 1b directement par modulation de phase des tons  haute fréquence $w_1$ et $w_2$ du signal à amplifier.

B" et C" sont réglables par les multiplieurs 7 et 11 séparément, en amplitude et en signe. La résultante R peut prendre toutes les valeurs en module $R = \sqrt{B''^2 + C''^2}$ et en phase $\phi = arc\ tg\ C''/B''$.

Le réglage se fait dans l'ordre décroissant des raies d'intermodulation à éliminer en observant à chaque  étape du réglage l'évolution du signal de sortie de l'amplificateur 1. Il consiste d'abord à minimiser les composantes situées aux fréquences $3f_1 - 2f_2$ et $3f_2 - 2f_1$ par action sur les amplificateurs linéaires à gain réglable 8 et 12, ce qui modifie également les composantes situées aux fréquences $2f_1 - f_2$ et $2f_2 - f_1$. Il consiste ensuite à minimiser les nouvelles composantes situées aux fréquences $2f_1 - f_2$ et $2f_2 - f_1$ par action sur les amplificateurs linéaires à gain réglable 7 et 11, ce qui joue un peu sur le niveau des fréquences $f_1$ et $f_2$, mais ceci n'est pas gênant.

Technologiquement, les éléments correcteurs n'étant pas parfaits, ils apportent intrinséquement certains défauts de linéarité dont le réglage peut tenir compte mais il est alors nécessaire de reprendre successivement les réglages par les couples 7, 11 puis 8, 12 pour obtenir la convergence nécessaire. A la fin du réglage, le spectre du signal de sortie de l'amplificateur non linéaire 1 comporte des raies d'intermodulation très affaiblies.

Les produits d'intermodulation dus à la non linéarité de l'amplificateur 1 appliquée aux signaux de corrections issus du dispositif de correction ont un niveau très faible et sont de ce fait négligeables.

A titre d'exemple, la description du fonctionnement du dispositif de correction de non linéarité conforme à l'invention a été faite pour un signal d'entrée comportant deux tons haute fréquence égaux mais le principe de l'invention est inchangé pour un signal d'entrée comportant un nombre quelconque de tons eux-mêmes quelconques.

REVENDICATIONS

1. Dispositif de correction d'intermodulation produite par un amplificateur (1) de signaux haute fréquence régulé en niveau crête, à coefficients de non linéarité complexes, caractérisé en ce qu'il comporte des moyens (2) d'élaboration de raies correctrices pour élaborer, à partir du signal haute fréquence à amplifier, un signal d'entrée de l'amplificateur (1) dont le spectre comporte, outre les raies haute fréquence du signal à amplifier, des premières raies correctrices d'amplitude réglable aux fréquences des produits d'intermodulation d'ordres impairs, et des secondes raies correctrices d'amplitude réglable aux fréquences des produits d'intermodulation d'ordres impairs, et déphasées de $\frac{\pi}{2}$ par rapport aux premières raies correctrices, le produit des fonctions de transfert des moyens (2) d'élaboration de raies correctrices et de l'amplificateur (1) ne donnant pas nécessairement une fonction de transfert linéaire.

2. Dispositif de correction d'intermodulation selon la revendication 1, caractérisé en ce qu'un détecteur d'enveloppe (3) du signal à amplifier est prévu en entrée des moyens (2) d'élaboration de raies correctrices.

3. Dispositif selon les revendications 1 et 2, caractérisé en ce que les moyens (2) d'élaboration de raies correctrices comportent premièrement N multiplieurs (5, 6), dont le premier est muni de deux entrées reliées à la sortie du détecteur d'enveloppe (3), dont le deuxième est muni de deux entrées reliées à la sortie du premier et dont le $n^{ième}$ (n étant entier compris entre 3 et N) est muni de deux entrées reliées respectivement à la sortie du premier et du $(n-1)^{ième}$, deuxièmement N premiers amplificateurs linéaires (7,8) à gain réglable en amplitude et en signe, munis chacun d'une entrée reliée à la sortie de l'un des N multipleurs (5, 6), et N seconds amplificateurs linéaires (11,12) à gain réglable en amplitude et en signe, munis chacun d'une entrée reliée à la sortie de l'un des N multiplieurs (5,6), troisièmement un premier circuit sommateur (9) muni de N + 1 entrées, N de ces entrées étant reliées aux sorties des N premiers amplificateurs à gain réglable, la $(N + 1)^{ième}$ recevant une constante (K), et un second circuit sommateur (13) muni de N entrées reliées aux sorties des N seconds amplificateurs a gain réglable, quatrièmement un modulateur de phase (14) muni d'une entrée haute fréquence qui reçoit le signal à amplifier et d'une entrée basse fréquence qui est reliée à la sortie du second circuit sommateur (13), et cinquièmement un modulateur d'amplitude (10) muni d'une entrée haute fréquence qui est reliée à la sortie du modulateur de phase (14), d'une entrée basse fréquence qui est reliée à la sortie du premier circuit sommateur (9), et d'une sortie qui fournit le signal d'entrée de l'amplificateur (1).

4. Dispositif selon les revendications 1 et 2, caractérisé en ce que les moyens (2) d'élaboration de raies correctrices comportent premièrement N multiplieurs (5, 6), dont le premier est muni de deux entrées reliées à la sortie du détecteur d'enveloppe (3), dont le deuxième est muni de deux entrées reliées à la sortie du premier et dont le $n^{ième}$ (n étant entier compris entre 3 et N) est muni de deux entrées reliées respectivement à la sortie du premier et du $(n-1)^{ième}$, deuxièmement N premiers amplificateurs linéaires (7, 8) à gain réglable en amplitude et en signe munis chacun d'une entrée reliée à la sortie de l'un des N multiplieurs (5, 6) et N seconds amplificateurs linéaires (11, 12) à gain réglable en amplitude et en signe, munis chacun d'une entrée reliée à la sortie de l'un des N multiplieurs (5, 6), troisièmement un premier circuit sommateur (9) muni de (N + 1) entrées, N de ces entrées étant reliées aux sorties des N premiers amplificateurs à gain réglables (7, 8) la $(N+1)^{ième}$ recevant une constante (K), et un second circuit sommateur (9) muni de N entrées reliées aux sorties des N seconds amplificateurs réglables (11, 12), quatrièmement un dispositif (15) apte à effectuer une modulation de phase en supprimant la porteuse dans le spectre du signal modulé en phase, muni d'une entrée haute fréquence qui reçoit le signal à amplifier et d'une entrée basse fréquence qui est reliée à la sortie du second circuit sommateur (13), cinquièmement un modulateur d'amplitude (10) muni d'une entrée haute fréquence qui reçoit le signal à amplifier et d'une entrée basse fréquence qui est reliée à la sortie du premier circuit sommateur (9), et sixièmement une troisième circuit sommateur (16) muni d'une entrée reliée à la sortie du dispositif (15), d'une entrée reliée à la sortie du modulateur d'amplitude (10) et d'une sortie qui fournit le signal d'entrée de l'amplificateur (1).

Fig.1a

Fig.1b

Fig.2a

Fig.2b

Fig.2c

Fig.2d

Fig.3a

Fig.3b

2/5

0085600

$k_7 \frac{A^2}{2} + k_8 \cdot 3\frac{A^4}{8} + K$

$k_7 \frac{A^2}{2} + k_8 \frac{A^4}{2}$

$k_8 \frac{A^4}{8}$

0    $\omega_2 - \omega_1$    $2(\omega_2 - \omega_1)$

**Fig.4a**

$k_{11} \frac{A^2}{2} + k_{12} \cdot 3\frac{A^4}{8}$

$k_{11} \frac{A^2}{2} + k_{12} \frac{A^4}{2}$

$k_{12} \frac{A^4}{8}$

0    $\omega_2 - \omega_1$    $2(\omega_2 - \omega_1)$

**Fig.4 b**

A′

B′

C′

$3\omega_1 - 2\omega_2$    $\omega_1$   $\omega_2$    $3\omega_2 - 2\omega_1$

$2\omega_1 - \omega_2$      $2\omega_2 - \omega_1$

**Fig.4 c**

**Fig.5a**

$\omega_0 - \omega$    $\omega_0$    $\omega_0 + \omega$

$(\omega_0 + \omega)t$

$+\omega t$

$-\omega t$

$(\omega_0 - \omega)t$

$\omega_0 t$

**Fig.5b**

**Fig.5 c**

$2\omega_1 - \omega_2$    $\omega_1$   $\omega_2$    $2\omega_2 - \omega_1$

$(2\omega_2 - \omega_1)t$

$\omega_2 t$

$\omega_1 t$

$(2\omega_1 - \omega_2)t$   **Fig.5 d**

$\omega_1 t$

$\omega_2 t$

0085600

Fig. 6 a

Fig. 6 b

Fig. 7a

Fig. 7b

0085600

$2\omega_1 - \omega_2$    $\omega_1$   $\omega_2$    $2\omega_2 - \omega_1$

Fig. 7c

$(2\omega_2 - \omega_1)t + \dfrac{\pi}{2}$    $\omega_2 t + \dfrac{\pi}{2}$

$(2\omega_1 - \omega_2)t + \dfrac{\pi}{2}$

$\omega_1 t + \dfrac{\pi}{2}$

$\omega_1 t$   $\omega_2 t$

Fig. 7d

R   B″   C″   C″   R

A″   A″   B″

$\omega_1 t$   $\omega_2 t$

Fig. 8a

C″   R

$\varphi$

B″

Fig. 8b

0085600

Europäisches
Patentamt

**EUROPÄISCHER RECHERCHENBERICHT**

**0085600**
Nummer der Anmeldung

EP 83 40 0124

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y | DE-A-2 306 294 (ROHDE & SCHWARZ) <br> * Figures 1,2; page 6, ligne 13 - page 10, ligne 22 * | 1-4 | H 03 F 1/32 |
| Y | IEEE TRANSACTIONS ON COMMUNICATIONS, vol. COM-24, no. 10, octobre 1976, pages 1139-1143, New York, USA <br> A.J. RUSTAKO et al.: "A wide-band phase-feedback inverse-sinc phase modulator with application toward a LINC amplifier" * Page 1139, colonne de droite, lignes 10-19 * | 1-4 | |
| E | EP-A-0 067 091 (THOMSON-CSF) <br> * Page 8; figure 1 * | 1-4 | |
| A | PROCEEDINGS OF THE IEEE, vol. 59, no. 2, février 1971, pages 230-238, New York, USA <br> O. SHIMBO: "Effects of intermodulation, AM-PM conversion, and additive noise in multicarrier TWT systems" * Pages 236-238, paragraphe VIII, "Method for reduction of intermodulations" | 1 | **RECHERCHIERTE SACHGEBIETE (Int. Cl. ³)** <br><br> H 03 F 1/32 <br> H 03 F 1/38 |

-/-

Der vorliegende Recherchenbericht wurde für alle Patentansprüche erstellt.

| Recherchenort <br> DEN HAAG | Abschlußdatum der Recherche <br> 25-03-1983 | Prüfer <br> LAMADIE G.Y.P. |
|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | PROCEEDINGS OF THE CONFERENCE ON EARTH STATION TECHNOLOGY, 14-16 octobre 1970, pages 274-279, Londres, G.B. A.F. STANDING: "An active-phase and amplitude-correction device for reducing the intermodulation produced by TWTS and Klystrons" * Page 276, lignes 9-14 * | | |
| A | AU-B- 483 960 (COMMUNICATIONS SATELLITE CORP.) * Page 4, lignes 2-13; page 5, lignes 6-9 * | 1 | |

RECHERCHIERTE SACHGEBIETE (Int. Cl. ³)

Der vorliegende Recherchenbericht wurde für alle Patentansprüche erstellt.

| Recherchenort DEN HAAG | Abschlußdatum der Recherche 25-03-1983 | Prüfer LAMADIE G.Y.P. |
|---|---|---|